# DEMANDE DE BREVET EUROPEEN

(11) **EP 2 648 119 A1**
(43) Date de publication de la demande: **09.10.2013**
(21) Numéro de dépôt: 13162402.5
(22) Date de dépôt: 04.04.2013
(51) Int. Cl.: G06F 17/50

(54) **Procédé de génération d'une interface interactive d'affichage de données**

(30) Priorité: 05.04.2012 FR 1253166
(71) Demandeur: Vinci Construction Grands Projets, 92500 Rueil Malmaison (FR)
(72) Inventeur: Tourtois, Jean-Marc, 60580 Coye la Forêt (FR)
(74) Mandataire: Novagraaf Technologies

(57) **Abrégé**

L'invention concerne un procédé de génération d'une interface interactive globale d'affichage de données relatives à un assemblage d'éléments constitutifs d'une construction architecturale modélisés en trois dimensions comportant les étapes suivantes :
○ réception d'un fichier numérique comportant au moins une représentation graphique ;
○ détection d'une pluralité d'objets compris dans ladite représentation graphique ;
○ identification à partir de ladite pluralité d'objets d'éléments constitutifs d'une construction architecturale ;
○ détermination à partir de ladite pluralité d'objets de relations et d'interactions entre les éléments constitutifs d'une construction architecturale identifiés de même catégorie ;
○ calcule à partir des relations et interactions déterminées entre les éléments constitutifs d'une construction architecturale identifiés d'un ensemble de critères définissant un assemblage d'éléments constitutifs d'une construction architecturale modélisés en trois dimensions.

## Description

### DOMAINE TECHNIQUE DE L'INVENTION

La présente invention a pour objet un procédé de génération d'une interface interactive d'affichage de données relatives à un assemblage d'éléments constitutifs d'une construction architecturale modélisés en trois dimensions, et un programme d'ordinateur.

Une utilisation particulière est aussi visée.

### ÉTAT DE LA TECHNIQUE

Dans l'industrie de la construction, et en particulier lors de l'édification de structures en béton de bâtiments industriels complexes, tels que des centrales nucléaires, outre les aciers de ferraillage passif et les éventuels câbles de précontrainte, une grande quantité de pièces est intégrée dans le béton et mise en place dans le coffrage avant coulage du béton.

Cette densité de pièces noyées dans le béton induit une augmentation de la complexité de réalisation de tels bâtiments, ce qui a une influence en terme de coût et de délai, et plus précisément en terme de fiabilité et de qualité de la mise en oeuvre du béton et qui peut affecter globalement la qualité et la sécurité de l'ouvrage fini.

On comprend donc que la conception et la coordination de ces pièces noyées qui doivent être réalisées de manière rigoureuse et sérieuse dès l'étude de conception ou d'exécution de l'ouvrage à une incidence déterminante sur le délai et le coût de la mise en oeuvre et sur sa qualité.

Généralement pour la réalisation de tels ouvrages architecturaux, de nombreux bureaux d'études et d'ingénierie sont mis à contribution. La multiplication de tels intervenants sur des projets de cette nature est souvent une source d'erreur potentielle qui est susceptible d'engendrer des problèmes retardant la livraison de l'ouvrage et entraînant une augmentation de son coût.

De fait, lors de la construction d'ouvrages en béton par exemple sur des sites sensibles, les équipes travaux se trouvent confrontées à la réalisation de structures lourdement ferraillées, voire précontraintes et incorporant un grand nombre de pièces noyées dans un environnement déjà embouteillé par la présence de multiples réservations et autres revêtements métalliques criblées de goujons de scellement. Des impossibilités de montage peuvent survenir, avec à la clef des non-conformités et retards de chantier.

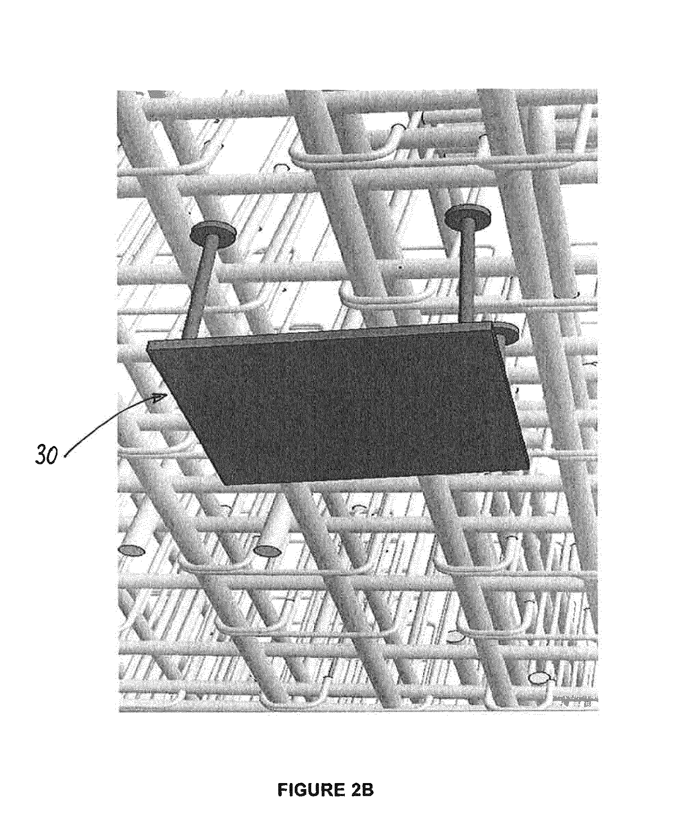

On aura compris que l'expression « ferraillage » couvre :
- les éléments de renforcement d'une pièce en béton, y compris les « aciers » (barres rectilignes ou non), coffrages, structures métalliques et inserts,
- et les éléments de fixation à la pièce béton de dispositifs ou pièces annexes (appareillages divers, structures..), ces éléments de fixation étant disposés en surface de la nappe de béton, dans laquelle ils sont toutefois ancrés via des parties noyés dans le béton (voir exemple ci-après figure 2B).

Quant à l'expression « conflits » utilisée ci-après, elle concerne les intersections de volumes d'au moins deux éléments d'assemblage préalablement modélisés en trois dimensions, y compris par conséquent les points de croisement et les adjacences trop immédiates entre deux tels éléments.

Dans ces conditions, pouvoir disposer d'un logiciel permettant de concevoir, modéliser, optimiser et simuler les assemblages de tels ferraillages complexes est un but à atteindre.

La présente invention vise alors résoudre les problèmes résultant des inconvénients de l'état de l'art.

### RESUME DE L'INVENTION

Pour ce faire, l'invention a pour objet un procédé de génération d'une interface interactive globale d'affichage de données relatives à un assemblage d'éléments constitutifs d'une construction architecturale modélisés en trois dimensions caractérisé en qu'il comporte les étapes suivantes
- réception d'un fichier numérique comportant au moins une représentation graphique ;
- détection d'une pluralité d'objets compris dans ladite représentation graphique ;
- identification à partir de ladite pluralité d'objets d'éléments constitutifs d'une construction architecturale ;
- détermination à partir de ladite pluralité d'objets de relations entre les éléments constitutifs d'une construction architecturale identifiés de même catégorie ;
- calcul à partir des relations déterminées entre les éléments constitutifs d'une construction architecturale identifiés d'un ensemble de critères définissant un assemblage d'éléments constitutifs d'une construction architecturale modélisés en trois dimensions.

Dans d'autres modes de réalisation :
- la représentation graphique se rapporte à :
   ■ un plan de coffrage du volume de béton ;
   ■ un plan de ferraillage ;
   ■ un plan de précontrainte ;
   ■ un plan de modèles de cage de ferraillage ;
   ■ un plan de platines et inserts noyés dans le béton ;
   ■ une combinaison d'au moins deux de ces plans, ou
   ■ représentation graphique résultant d'une numérisation laser trois dimensions.
- l'ensemble de critères comporte des sous-ensembles de critères définissant chacun un assemblage d'éléments constitutifs d'une construction architecturale modélisés en trois dimensions pour une catégorie donnée d'éléments constitutifs d'une construction architecturale ;
- chaque sous-ensemble de critères d'assemblage d'éléments constitutifs d'une construction architecturale modélisés en trois dimensions permet de générer une interface interactive d'affichage de données comportant une même catégorie d'éléments constitutifs d'une construction architecturale ;
- les catégories d'éléments constitutifs d'une construction architecturale se rapportent à :
   ■ des éléments de coffrage;
   ■ des réservations;
   ■ des inserts noyés;
   ■ des aciers de ferraillage passif ;
   ■ gaines et câbles de précontrainte ;
   ■ maquette trois dimensions d'un volume reconstituée à partir d'une numérisation laser trois dimensions ;
- l'objet se rapporte à des éléments graphiques ou textuels compris dans la représentation graphique ;
- un utilisateur peut modifier au moins un critère d'assemblage d'éléments constitutifs d'une construction architecturale modélisés en trois dimensions, d'un ensemble de critères ou d'un sous-ensemble de critères ;
- le procédé comprend une étape de détection d'une intersection de volumes d'au moins deux éléments constitutifs d'une construction architecturale modélisés en trois dimensions d'un assemblage ;
- le procédé comprend une étape de traitement apte à calculer de nouveaux critères d'assemblage d'un ensemble de critères ou d'un sous ensemble de critères de sorte à supprimer l'intersection détectée

L'invention se rapporte également à un programme d'ordinateur comportant des instructions pour l'exécution des étapes du procédé génération d'une interface interactive d'affichage de données relatives à un assemblage d'éléments constitutifs d'une construction architecturale modélisés en trois dimensions selon ledit procédé lorsque ledit programme est exécuté par les moyens d'un dispositif informatique.

Et dans le cadre de l'utilisation évoqué, il est prévu que, pour assembler des éléments modélisés en trois dimensions et constitutifs d'une construction en béton armé, avant de couler autour un volume de béton, d'un procédé de génération d'une interface interactive globale d'affichage de données relatives à un assemblage d'éléments, les étapes suivantes soient mise en oeuvre :
- réception d'un fichier numérique comportant au moins une représentation graphique ;
- détection d'une pluralité d'objets compris dans ladite représentation graphique ;
- identification à partir de ladite pluralité d'objets d'éléments constitutifs de la construction;
- détermination à partir de ladite pluralité d'objets de relations entre les éléments constitutifs de la construction identifiés de même catégorie ;
- calcul à partir des relations déterminées entre les éléments constitutifs de la construction identifiés d'un ensemble de critères définissant ledit assemblage d'éléments, ladite représentation graphique se rapportant à :
- un plan de coffrage du volume de béton ;
- un plan de ferraillage ;
- un plan de précontrainte ;
- un plan de modèles de cage de ferraillage ;
- un plan de platines et inserts noyés dans le béton ;
- une combinaison d'au moins deux de ces plans, ou
- une représentation graphique résultant d'une numérisation laser trois dimensions d'un objet préexistant, et/ou les catégories d'éléments constitutifs de la construction se rapportant à :
- des éléments de coffrage;
- des réservations;
- des inserts noyés;
- des aciers de ferraillage passif ;
- gaines et câbles de précontrainte ;
- une maquette en trois dimensions d'un volume de la construction cette maquette étant reconstituée à partir d'une numérisation laser trois dimensions d'un objet préexistant

Pour résoudre les difficultés, jusqu'à présent non identifiées avant que le montage sur le terrain le révèle, de superpositions de plusieurs éléments en un même emplacement de montage, il est par ailleurs conseillé :
- que l'étape de détection d'une intersection de volumes comprenne une détection d'intersections incompatibles (donc non identifiées lors d'une phase antérieure de préparation de travaux), en liaison avec une pose d'armatures à l'endroit d'un coffrage de maquette numérique préalablement modélisés :
   * entre des barres d'acier,
   * entre des barres d'acier et le coffrage, pour un respect des enrobages,
   * entre des barres d'acier et d'autres pièces à noyer au moins en partie dans le béton, et/ou.
- que la numérisation laser en trois dimensions d'un objet préexistant comprenne l'obtention d'un ensemble de points en trois dimensions illustratifs d'éléments de construction et recalés dans les coordonnées propres à la construction pour laquelle l'interface interactive est à générer, le passage d'une surface triangulée par ces points permettant d'obtenir ladite maquette scannée en trois dimensions,
- après quoi on fera interagir numériquement cette maquette numérisée avec ledit modèle des éléments constitutifs de l' assemblage, par ailleurs généré pour la construction, afin de détecter lesdites intersections possibles de volumes que :
- la numérisation laser en trois dimensions d'un objet préexistant comprend l'obtention d'un ensemble de points en trois dimensions illustratifs d'éléments de construction et recalés dans les coordonnées propres à la construction pour laquelle l'interface interactive est à générer, le passage d'une surface triangulée par ces points permettant d'obtenir ladite maquette scannée en trois dimensions,
- puis on fait interagir numériquement cette maquette numérisée avec ledit modèle des éléments constitutifs de cet assemblage, par ailleurs généré pour la construction, afin de détecter lesdites intersections possibles de volume entre des éléments de construction de la maquette et du modèle, respectivement.

### DESCRIPTION DES FIGURES

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs :
- Figure 1 représente un organigramme relatif au procédé selon un mode de réalisation de l'invention, et
- Figures 2A et 2B, une interface interactive d'affichage de données relatives à un assemblage d'éléments constitutifs d'une construction architecturale lorsque cet élément est l'acier de ferraillage passif, selon un mode de réalisation de l'invention,
- et les figures 3, 4, 5, 6, 7, 8, 9a, 9b, 10,11,12 et 13 illustrent des situations d'utilisation du procédé ici présenté, dans des exemples.

### MODES DE REALISATION DE L'INVENTION.

Dans un mode de réalisation de l'invention, le procédé de génération d'une interface interactive d'affichage de données relatives à un assemblage d'éléments constitutifs d'une construction architecturale modélisés en trois dimensions est mis en oeuvre par un dispositif informatique relié à des bases de données.

De manière générale, ce dispositif informatique correspond, de manière non limitative, à tous dispositifs comprenant :
- des moyens de traitement : au moins un microprocesseur, et des moyens de mémoire (mémoire volatile et/ou non volatile et/ou de masse) ;
- des moyens de saisie, tel qu'un clavier et/ou une souris et/ou écran tactile, ou encore à des moyens de commande vocale ;
- des moyens d'affichage ;
- des moyens de communication ;

Les moyens de communication de ce dispositif se rapportent par exemple aux technologies et/ou normes suivantes :
- WI-FI (abréviation de wirelessfidelity) et/ou Wimax, et GPRS (General Packet Radio Service), GSM, UMTS, HSDPA ou IMS (IP MultimediaSubsystem), ou
- Ethernet.

On notera, en particulier, que ces moyens de communication sont compatibles avec les moyens de communication du serveur mettant en oeuvre les bases de données.

Les moyens de traitement de ce dispositif informatique sont aptes à mettre en oeuvre un code informatique se rapportant à un algorithme correspondant à un programme d'ordinateur, archivé dans les moyens de mémoire du dispositif informatique, comportant des instructions aptes à effectuer les traitements nécessaires pour réaliser les étapes du procédé selon un mode de réalisation de l'invention.

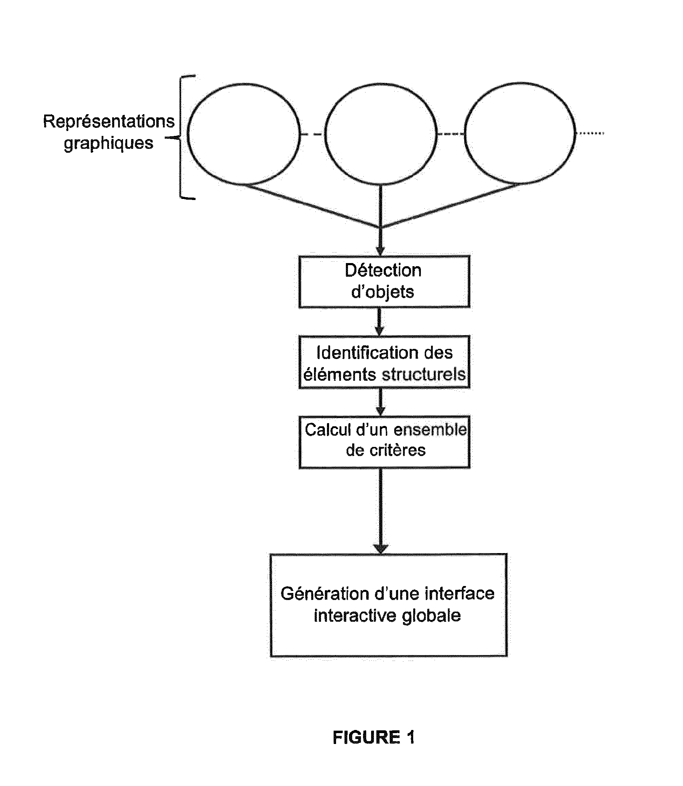

Ainsi qu'il est illustré à la figure 1, le procédé de génération d'une interface interactive d'affichage de données relatives à un assemblage d'éléments constitutif d'une construction architecturale modélisés en trois dimensions comporte une étape de réception d'un fichier numérique comprenant au moins une représentation graphique.

Cette représentation graphique est généralement en deux dimensions et se rapporte de manière non exhaustive à :
- un plan de coffrage du volume de béton ;
- un plan de ferraillage, avec des nomenclatures de façonnage d'aciers ;
- un plan de précontrainte avec nomenclatures de façonnage des gaines ;
- un plan de platines et inserts noyés dans le béton,
   ou
- plans de réseaux ou de réservation ;
- une combinaison d'au moins deux de ces plans ;
- représentation graphique résultant d'une numérisation laser trois dimensions.

On notera que dans un autre mode de réalisation, ce fichier numérique peut également se rapporter à des données textuelles de conception d'ingénieur : notes de calculs, croquis de ferraillage avec sections minimales d'aciers et croquis de précontrainte.

Le procédé est alors apte à analyser et interpréter le contenu de cette représentation graphique, en détectant, lors d'une étape de détection, une pluralité d'objets compris dans ladite représentation graphique.

Ces objets correspondent par exemple et ce de manière non exhaustive à des éléments graphiques ou encore textuels.

En particulier l'étape de détection vise à extraire tous les éléments graphiques et/ou textuels susceptibles de permettre l'identification d'un élément constitutif d'une construction architecturale compris dans la représentation graphique.

Ces éléments graphiques ou textuels correspondent par exemple dans :
- des plans de coffrage du volume de béton en deux dimensions à des : dimensions et forme des poteaux, poutres, dalles, voiles, ouvertures etc... ;
- des plans de ferraillage en deux dimensions, avec des nomenclatures de façonnage d'aciers à des :
   identification, type de forme, dimensions, quantités et positionnement ;
- des plans de précontrainte avec nomenclatures de façonnage des gaines en deux dimensions à des : identification, type de forme, dimensions, quantités et positionnement ;
- plans des platines et inserts noyés dans le béton à des : identification, type de forme, dimensions, quantités et positionnement.

Les bases de données comportent des bibliothèques paramétrées de façonnage de fabrication des aciers, lesquelles sont mises en place conformément aux différents règlements et/ou aux matériel de façonnage.

Une fois la pluralité d'objets extrait de la représentation graphique ils sont archivés dans les moyens de mémoire du dispositif informatique en vue de leur traitement, de sorte à déterminer, en fonction de données d'objets stockées dans une base de données dite de « référence », les éléments constitutifs d'une construction architecturale compris dans ladite représentation graphique.

La base de données de référence comporte pour chaque catégorie d'éléments constitutifs d'une construction architecturale une correspondance à un ou plusieurs objets permettant d'identifier ledit élément constitutif d'une construction architecturale.

Un élément constitutif d'une construction architecturale peut être défini soit par un objet soit par une combinaison d'objets.

Une fois que les éléments constitutifs d'une construction architecturale compris dans la représentation graphique sont identifiés, le procédé prévoit une étape de détermination des caractéristiques de chaque élément constitutif d'une construction architecturale identifié. Ces caractéristiques correspondent par exemple à la topologie, aux dimensions, et aux volumes de ces éléments constitutifs d'une construction architecturale ainsi qu'à la distance qu'il y a entre chaque élément constitutif d'une construction architecturale, et la position de chaque élément dans la représentation graphique.

Ce procédé permet alors de générer pour chaque élément constitutif d'une construction architecturale identifié dans la représentation graphique un élément constitutif d'une construction architecturale modélisé en trois dimensions à partir du traitement de données relatives à :
- l'identification de l'élément constitutif d'une construction architecturale ;
- l'identification de sa catégorie ;
- la détermination des caractéristiques de chaque élément constitutif d'une construction architecturale.

Ces éléments constitutifs d'une construction architecturale modélisés en trois dimensions se rapportent par exemple à :
- des éléments de coffrage ;
- des éléments de réservations ;
- des inserts noyés ;
- des aciers de ferraillage passif ;
- les gaines et câbles de précontrainte ;
- l'enrobage ;
- maquette trois dimensions d'un volume reconstituée à partir d'une numérisation laser trois dimensions ;
- tout autre type d'élément constitutif d'une construction architecturale destiné à être intégré dans le béton.

Ainsi, le procédé peut alors calculer à partir des relations entre les éléments constitutifs d'une construction architecturale identifiés, un ensemble de critères définissant un assemblage des éléments constitutifs d'une construction architecturale modélisés en trois dimensions.

Cet ensemble de critère comporte des sous-ensembles de critères. Chaque sous ensemble de critères défini le mode d'assemblage des éléments constitutifs d'une construction architecturale modélisés en trois dimensions pour une catégorie donnée d'éléments constitutifs d'une construction architecturale.

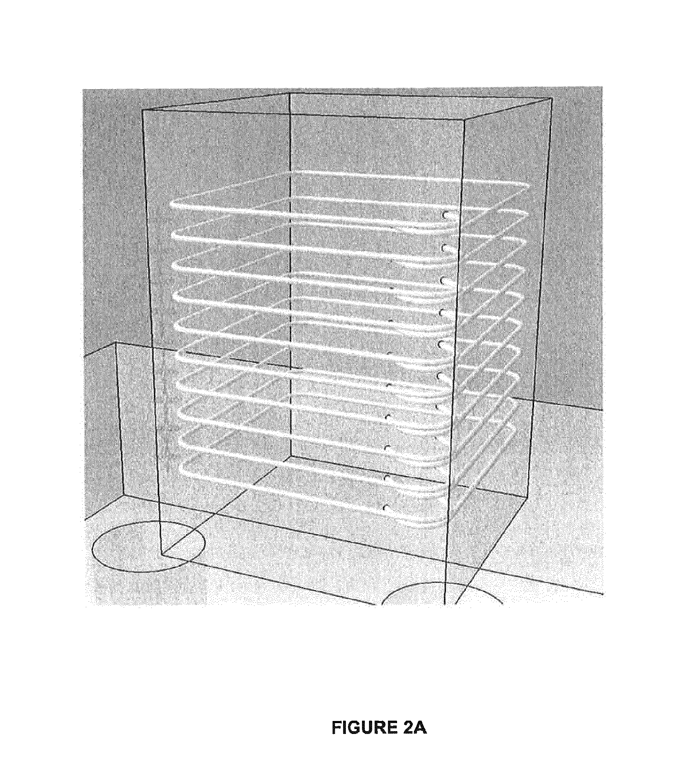

Dès lors, à partir d'un sous-ensemble de critères un assemblage des aciers de ferraillage passif peut donc être réalisé et donc permettre d'obtenir une interface interactive d'affichage de données relatives à un assemblage d'éléments constitutifs d'une construction architecturale modélisés en trois dimensions. Cette interface peut également être considérée comme une maquette en trois dimensions de l'acier de ferraillage passif mis en oeuvre dans la représentation graphique, et correspondant à un plan de ferraillage réalisé pour construction architecturale. Un exemple de cette maquette en trois dimensions est illustré en figure 2A et 2B.

Le procédé permet donc de réaliser ainsi pour chaque sous-ensemble de critères calculé, des interfaces interactives relatives à l'assemblage d'éléments constitutifs d'une construction architecturale même catégorie.

Lors d'une étape de génération d'une interface interactive dite « globale », l'ensemble des interfaces relatives à l'assemblage d'éléments constitutifs d'une construction architecturale même catégorie sont superposées de sorte à permettre l'identification de tout problème qui pourrait se poser au cours de la construction de l'ouvrage architectural, tel que le positionnement incorrect d'un élément constitutif d'une construction architecturale, de même catégorie ou pas, par rapport à un autre.

On notera qu'une telle interface interactive globale peut être également générée directement à partir de l'ensemble de critères d'assemblage.

Ainsi, le procédé comporte une étape d'identification de tels problèmes et/ou conflits entre au moins deux éléments constitutifs d'une construction architecturale.

En effet, il est important de noter que la bonne coordination des différents éléments constitutifs d'une construction architecturale noyés dans le béton, est assurée par la suppression des conflits détectés dans l'interface interactive globale.

Plus particulièrement, un conflit entre deux éléments constitutifs d'une construction architecturale noyés dans le béton est constitué dès lors qu'il y a une intersection de leurs volumes respectifs au-delà d'une valeur seuil prédéfinie, ladite valeur seuil pouvant être négative.

Dès lors, le procédé comporte une étape de traitement apte à calculer de nouveaux critères d'assemblage d'un ensemble de critères ou d'un sous-ensemble de critères de sorte à supprimer l'intersection qui aura été détectée.

Ainsi la définition de nouveaux critères, d'un ensemble de critères ou d'un sous ensemble de critères, redéfinie dans l'assemblage des éléments constitutifs d'une construction architecturale modélisés en trois dimensions, la position spatiale d'un ou de plusieurs éléments constitutifs d'une construction architecturale dans cet assemblage de sorte à supprimer ce conflit sans en engendrer un autre.

Chaque conflit est évalué par sa profondeur de pénétration selon par exemple une règle relative à la plus grande distance normale aux faces des objets.

Les conflits détectés sont classés par profondeur de pénétration croissante ou décroissante.

La tolérance sur un conflit est la profondeur de pénétration en dessous de laquelle le conflit est ignoré.

Cette étape de traitement permettant de calculer de nouveaux critères d'assemblage comporte une sous-étape de détection de ces conflits qui est fonction de certaines conditions préalables relatives à la :
- la définition des tolérances par type de conflit (pénétration maxi autorisée des volumes) ;
- l'identification / quantification des conflits non tolérés.

A titre d'exemple, les conflits principaux détectés et visualisés mettent généralement en cause les couples d'éléments constitutifs d'une construction architecturale suivants :
- conflit aciers de ferraillage passif / aciers de ferraillage passif ;
- conflit aciers de ferraillage passif / enrobage ;
- conflit aciers de ferraillage passif / inserts noyés ;
- conflit gaines et câbles précontrainte / gaines et câbles précontrainte ;
- conflit gaines et câbles précontrainte / enrobage ;
- conflit gaines et câbles précontrainte / inserts noyés ;
- conflit inserts noyés / inserts noyés ;
- conflit aciers de ferraillage passif / gaines et câbles précontrainte.

L'interface interactive globale, tout comme l'interface interactive pour chaque catégorie d'éléments constitutifs d'une construction architecturale, peut être modifiée. En effet, un utilisateur peut modifier au moins un critère d'assemblage d'éléments constitutifs d'une construction architecturale modélisés en trois dimensions, d'un ensemble de critères ou d'un sous-ensemble de critères.

Par exemple à partir des moyens de saisie du dispositif informatique cet utilisateur peut manipuler chaque élément constitutif d'une construction architecturale modélisé en trois dimensions compris dans cette interface sans générer de conflit, c'est-à-dire sans engendrer par cette manipulation une intersection de volume d'au moins deux éléments constitutifs d'une construction architecturale modélisés en trois dimensions. Lors de la réalisation de cette manipulation par l'utilisateur d'un tel élément constitutif d'une construction architecturale de l'interface, les moyens de traitement du dispositif calculent en temps réels de nouveaux critères d'assemblage qui tiennent compte d'un paramètre visant à éviter tout conflit entre l'élément en cours de manipulation et le reste des éléments constitutifs d'une construction architecturale modélisés.

L'utilisateur peut également en sélectionnant un élément constitutif d'une construction architecturale modélisé en trois dimensions dans l'interface globale, ou dans l'interface interactive pour chaque catégorie d'éléments constitutifs d'une construction architecturale, générer l'affichage d'un ensemble de données d'information relatives audit élément sélectionné. Ce sont des informations qui sont stockées dans les bases de données auxquelles est relié le dispositif informatique, et qui correspondent par exemple à :
- édition de la nomenclature des aciers de la modélisation tridimensionnelle des aciers de ferraillage passif à tout état d'avancement
- extraction de modèles des cages de ferraillage depuis la modélisation tridimensionnelle d'aciers de ferraillage passif en vue de l'étude de leur déformabilité en cours de manipulation ou en vue de leur insertion dans un modèle de calcul aux éléments fini du béton armé ;
- extraction des plans de ferraillage et leurs nomenclatures ;

On notera en particulier que ce procédé peut par exemple être utile pour des chefs de chantiers en charges de la réalisation d'ouvrages, comme une méthode d'assistance dynamique à la résolution de conflit, ainsi qu'un déplacement sous contrainte avec arrêt sur collision d'un élément constitutif d'une construction architecturale noyés ou d'un ensemble d'éléments constitutifs d'une construction architecturale quelconque à l'intérieur de ladite interface globale.

Ainsi, le procédé permet par exemple de réaliser :
- des rapports de conflits à l'usage des corps d'état, client, chantier et les propositions d'adaptations pour résoudre chaque conflit ;
- une étude de la faisabilité et de l'optimisation de l'insertion d'un objet (platine, insert ...) dans une interface interactive globale : recherche et visualisation de la trajectoire optimale de mise en place d'un platine dans une cage de ferraillage ;
- une étude de la faisabilité et de l'optimisation de l'insertion d'une interface interactive relative à une catégorie d'éléments constitutifs d'une construction architecturale modélisés en trois dimensions dans une autre pour atteindre une configuration donnée de la réunion des deux interfaces interactive : recherche et visualisation de la trajectoire optimale de mise en place d'un élément préfabriqué de cage d'armature dans un autre;
- une étude de la faisabilité et de l'optimisation d'un phasage de mise en oeuvre d'une interface interactive globale : recherche et visualisation séquence optimale de mise en place des éléments préfabriqués de cage d'armature ;
- une prise en compte de la réalité mise en oeuvre :
   insertion/exploitation dans l'interface interactive globale d'une numérisation laser 3D d'un objet existant : recherche et visualisation de la mise ne place d'une cage d'armatures dans une structure existante scannée en 3D ;
- génération d'un modèle de calcul « filaire » de la cage de ferraillage en vue de l'étude de leur déformabilité en cours de manipulation et/ou intégration à un modèle du « composite » béton armé de tout ou partie de la structure.

Pour compléter la compréhension, considérons maintenant un exemple opérationnel.

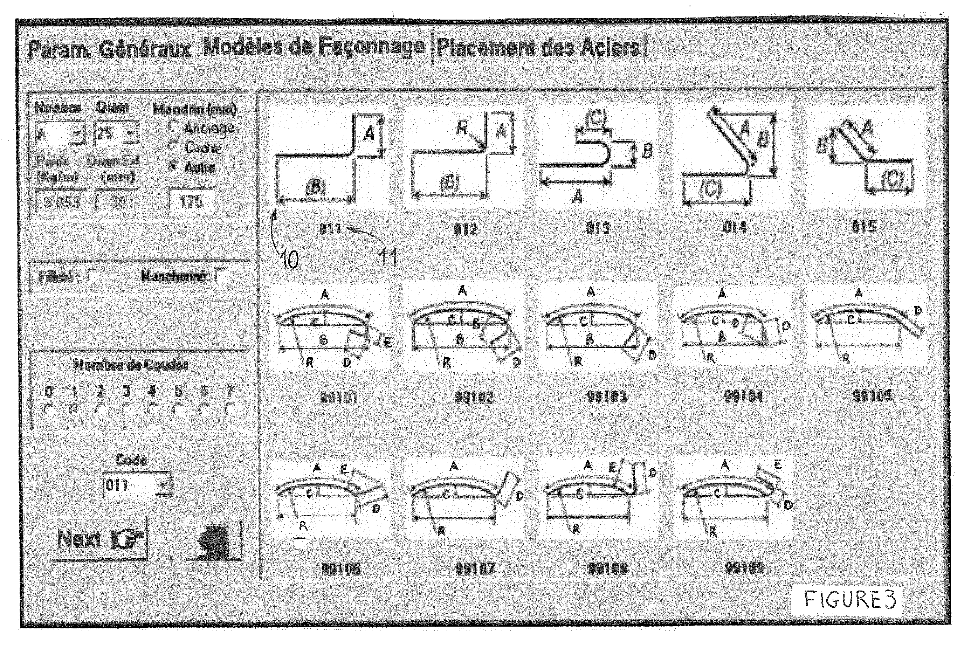

Figures 3 à 7, on voit un ainsi exemple de modélisation, façonnage et placement de nappes d'aciers en respect des normes. Des bibliothèques complètes (ISO pour la France et l'Europe ou British Standards pour le Royaume-Uni) ont été créées et mises en place. Ces éléments de bibliothèque sont intelligents et s'adaptent automatiquement aux normes de façonnage retenues et aux formes de l'ouvrage à construire déjà modélisées.

Figure 3, l'opérateur choisit le type de façonnage de l'acier parmi plusieurs disponibles à l'écran, via son logiciel. On constate qu'il a sélectionné en 11 le type 011 (référence fléchée 10).

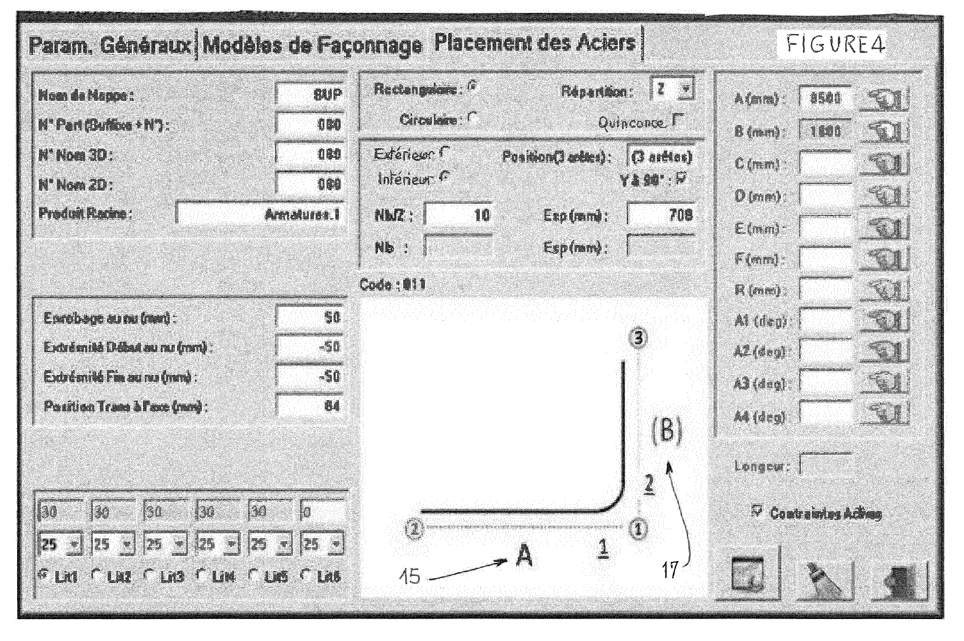

Figure 4, l'opérateur définit le placement de la nappe d'acier dans le coffrage, en définissant des dimensions, telle, en 13, l'enrobage dans le béton de ce ferraillage et en 15,17 respectivement les longueurs A et B de la barre en « L » choisie.

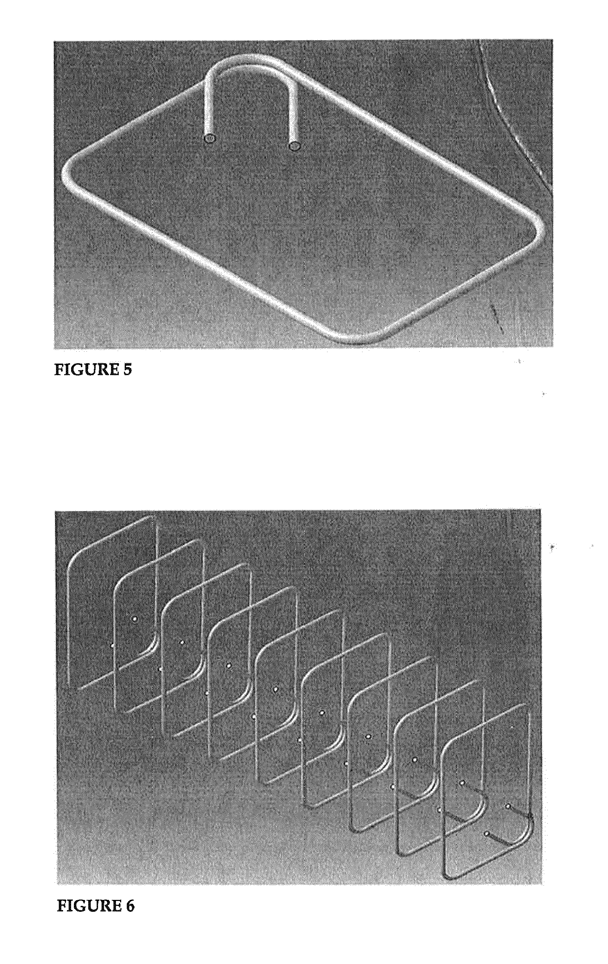

Figure 5 on voit qu'il y a alors génération en machine et à l'écran de la barre retenue et, figure 6, de la nappe complète comprenant une série (prédéfinie) de telles barres.

L'opération se poursuit si nécessaire pour d'autres barres, nappes, types d'enrobage...

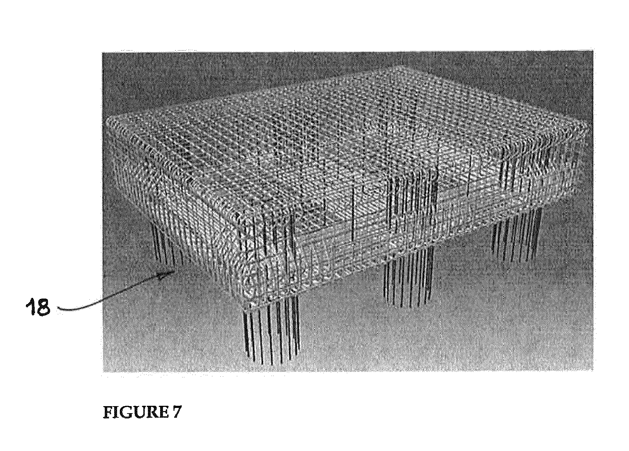

Comme montré figure 7, le logiciel simule finalement automatiquement, sur la maquette numérique 18, le placement dans le coffrage de l'ensemble des nappes prédéfinies.

Ceci fait, le logiciel va détecter les conflits de pose des armatures (non détectés lors de la phase antérieure de préparation des travaux) :
- des aciers (barres) entre eux,
- entre les aciers et le coffrage (respect des enrobages),
- entre les aciers et les pièces noyées autres (canalisations, autres tubes....).

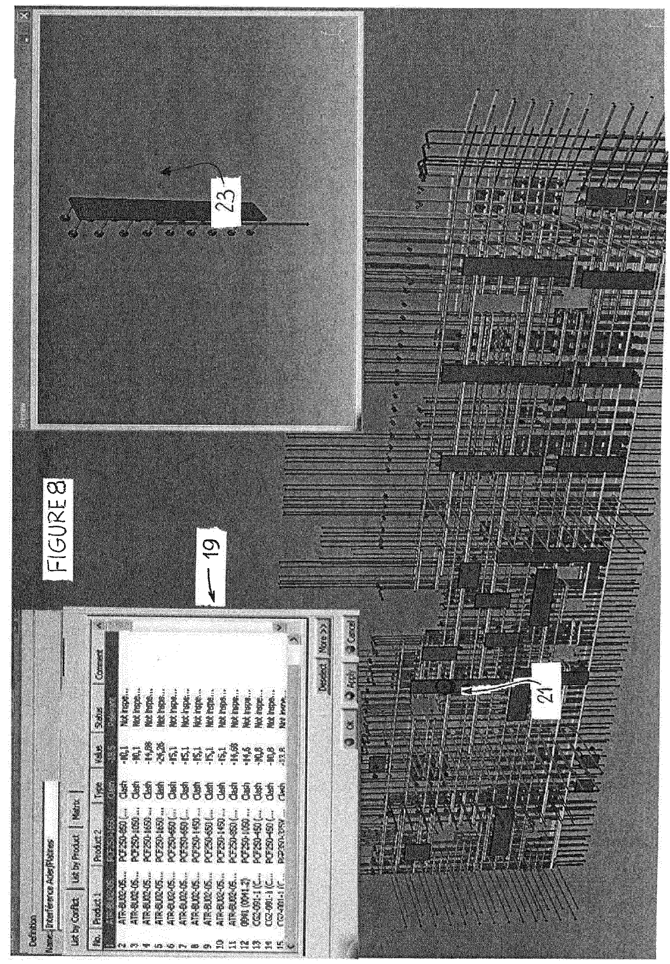

Figure 8, on voit ce qui apparait à l'écran, avec :
- la liste 19 des conflits détectés dans le placement « théorique » (sur la maquette numérique modélisée) précitée,
- l'affichage sur cette maquette numérique, telle celle figurée en 21, du conflit que l'opérateur aura sélectionné dans la liste 19, et, en 23, un zoom (agrandissement) du conflit.

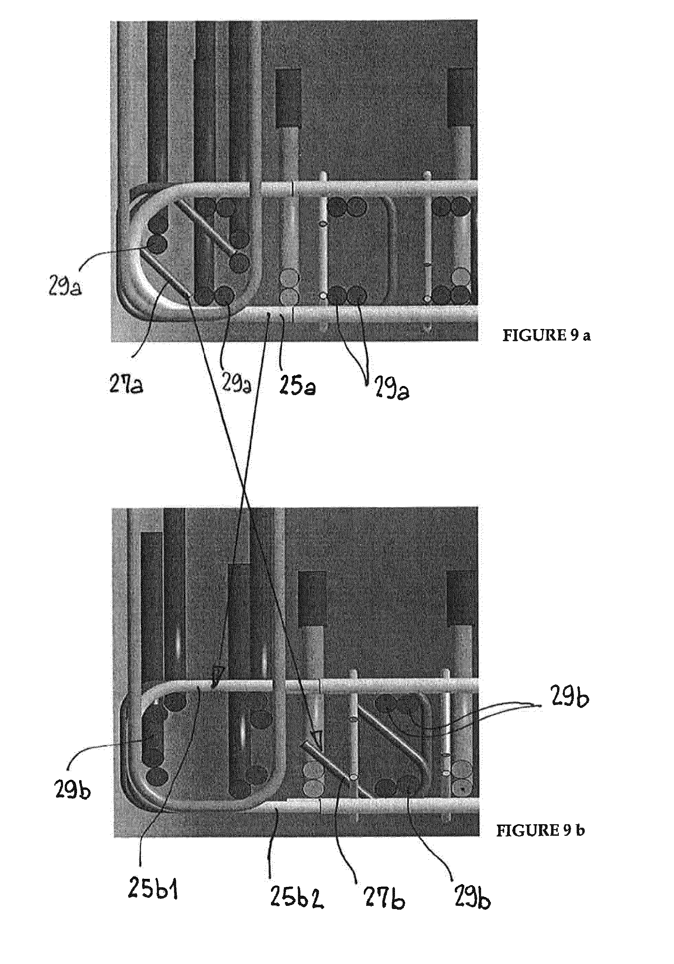

Il va alors être possible d'adapter le ferraillage pour en simplifier la mise en oeuvre, comme montré figures 9a, 9b.

Par exemple ici dans cette coupe horizontale d'un chainage vertical en vue de dessous :
- le logiciel permet à l'opérateur de remplacer le U 25a par deux cadres de diamètre inférieur 25b1, 25b2,
- inverser l'ancrage du cadre référencé, de 27a en 27b,
- déplacer quelques aciers (tels 29a en 29b).

Si cela ne crée pas de nouveaux problèmes détectés via le logiciel, la machine autorise et effectue ces remplacement, inversion et déplacement.

Sinon, cela est signalé à l'opérateur et non enregistré en mémoire.

En outre, le logiciel va permettre de résoudre interactivement les conflits en adaptant le ferraillage en accord avec les dispositions constructives du chantier, tout en garantissant de ne pas créer de conflits additionnels ailleurs.

Par exemple :
- dans la liste des conflits, on sélectionne une platine 30 (à placer dans un ferraillage puis à ancrer là ; cf. figure 2B). Si des ancrages de cette platine entrent en conflit avec le ferraillage, et comme il est interdit de déplacer la platine, l'operateur est amené à modifier via l'écran et son logiciel, et/ou à adapter les positions des barres du ferraillage,
- il peut être choisi par l'opérateur de déplacer à l'aide de la souris des barres du ferraillage et de les repositionner jusqu'au contact de l'ancre de la platine ou d'un autre objet au choix (platine ou acier),
- l'opération terminée garantit que le conflit a été résolu et qu'aucun nouveau conflit n'a été introduit,
- lors de la conception d'un nouveau ferraillage, ce processus est reconduit à chaque mise en place d'une nouvelle nappe. Ainsi, se construit méthodiquement un ferraillage sans conflit.

Par ailleurs, l'émission de rapport de conflits sera de préférence possible.

Ces rapports rassembleront de préférence toutes les adaptations, accompagnés de modèles 3D publiés consultables sur ordinateur ou tablette tactile. Ces modèles seront favorablement interactifs et permettront au chantier de réaliser en dynamique toute vue (dessus, face côté..), mesure ou coupe.

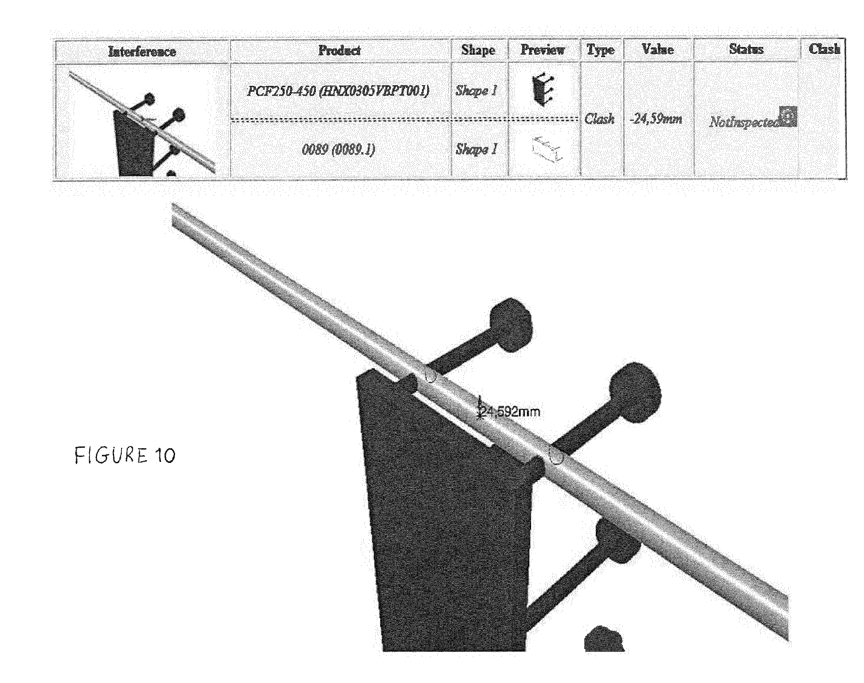

La figure 10 montre que chaque conflit sera traité par un lien vers un fichier, de préférence xml, qui détaillera le conflit et sa solution de résolution.

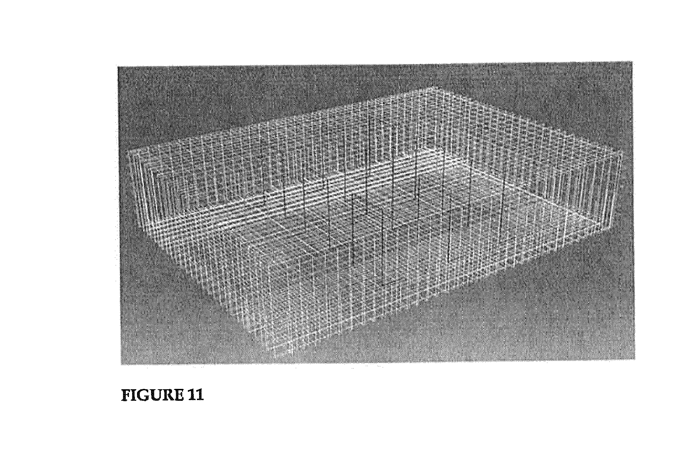

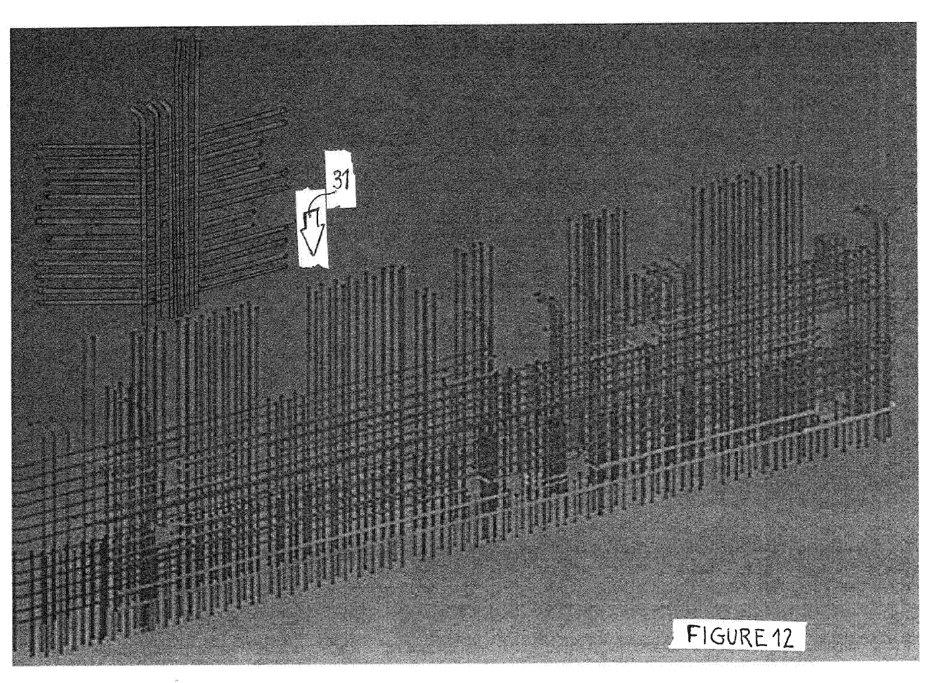

En outre, favorablement, le logiciel va offrir, à partir de la maquette 3D, une assistance à la production, par conversion :
- de plans de ferraillage 2D (en deux dimensions) conventionnels, et/ou,
- de vues 3D (en trois dimensions) du ferraillage qui sont souvent plus explicites que des plans 2D classiques Il va être de préférence par ailleurs possible :
- de générer des modèles de calculs simplifiés pour la validation de la stabilité et la non-déformabilité des cages de ferraillage (voir un exemple figure 11). Les barres 3D seront avantageusement automatiquement remplacées par des axes symboliques en s'affranchissant des crosses d'ancrage et des coudes. On obtiendra ainsi de préférence une maquette transférable vers un logiciel de calcul de structure intégrant les caractéristiques géométriques et mécaniques (diamètre, nuance d'acier, ...) de chaque barre nécessaires aux calculs à réaliser, et/ou
- de réaliser des simulations de montage des cages avec détection de conflits : Afin de s'assurer de la bonne faisabilité du montage de cages d'armatures (de ferraillage), des cinématiques affichables sur écran, comme illustré figure 12, flèche 31, de mise en place des cages avec détection de conflits, permettront alors de valider, en bureau, le bon phasage d'exécution des travaux de ferraillage. Il pourra même être alors possible de réaliser des animations montrant l'évolution des travaux de ferraillage dans le temps (4D).

Des publications 3D (fichiers compressés compatibles pour un envoi par e-mail) peuvent être produites pour être utilisées sur le terrain/chantier.

Les équipes travaux pourront alors notamment consulter la maquette 3D, afficher ou masquer des barres, prendre des mesures et réaliser des coupes ou des sections, si nécessaire en dynamique.

Autre possibilité : Intégrer des images d'ouvrages déjà construits issues d'un scanner 3D, pour adapter les futures cages à la réalité de l'existant.

La technologie du Scanner 3D consiste à faire balayer une structure existante, si nécessaire en plusieurs passes, par un scanner laser. Le résultat peut être un ensemble de plusieurs dizaines de millions de points 3D. Les points scannés (donc saisis et enregistrés) sont traités pour éliminer ceux inutiles ou trop distants, ou les points immédiatement voisins ou adhérents. On obtient un ensemble de points 3D recalés dans les coordonnées du projet. On fait passer une surface triangulée par ces points pour obtenir le modèle scanné qui peut interagir avec le modèle 3D généré par le logiciel.

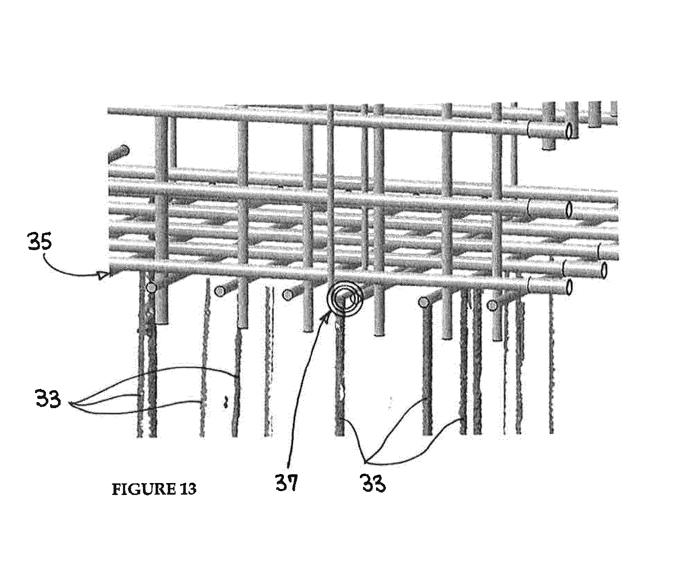

Figure 13, on voit ainsi :
- en 33 des attentes existantes, c'est-à-dire le ferraillage déjà en place, scanné(es) et alors affiché(es) sur l'écran, ici des barres verticales,
- en 35, le modèle 3D créé par le logiciel (ici une cage de ferraillage complémentaire) et qui est donc, dans l'exemple, à mettre en place sensiblement au niveau du sommet de ces barres,
- de là, en 37, la détection automatique et l'indication (visuelle, sonore ou autre) de conflit(s) lors de la simulation de la descente de cette cage préassemblée.

Ainsi, il a été possible d'assurer :
- des relevés du ferraillage déjà en place sur le chantier, par scanner (ou tout moyen d'acquisition numérique permettant d'acquérir des séries de points relevés dans les trois dimensions ; ainsi le terme « scanner » couvre toute technique d'acquisition ayant cette capacité et permettant donc d'obtenir des relevés topographiques réalisés in-situ, par exemple par le géomètre du chantier),
- une modélisation des relevés permettant de simuler, sur écran, tant le ferraillage scanné que le ferraillage encore à ajouter,
- la simulation de la présentation, sur écran, du ferraillage encore à ajouter au ferraillage scanné affiché,
- la détection de possibles conflits (points de croisement / adjacence trop immédiate...) entre le ferraillage déjà en place et celui encore à placer conformément au plan préétabli, donc au moins entre aciers (barres rectilignes ou non), coffrages, structures métalliques et inserts,
- puis la réalisation d'une animation des phases de montage, avec détection des conflits, scanné, avant coulage du béton, Une communication avec le chantier s'est faite, à distance, à l'aide de publications 3D de la maquette échangées par mail,
- et, si besoin, de (s) plans d'exécution 2D traditionnels qui ont pu être dessinés à partir des informations générées par la maquette 3D.

A partir de la détection des conflits, la maquette 3D du ferraillage existant a pu être adaptée aux mesures effectuées sur site et la structure encore à ajouter (par exemple une future cage d'armature) a pu être modifiée pour s'intégrer à l'existant.

Il a en outre été possible de contrôler que le futur ferraillage était adapté sur site à la position réelle du ferraillage déjà en place.

## Revendications

1. Procédé de génération d'une interface interactive globale d'affichage de données relatives à un assemblage d'éléments constitutifs d'une construction en béton armé modélisés en trois dimensions, comportant les étapes suivantes :
- une réception d'un fichier numérique comportant au moins une représentation graphique ;
- une détection d'une pluralité d'objets compris dans ladite représentation graphique ;
- une identification à partir de ladite pluralité d'objets d'éléments constitutifs de la construction;
- une détermination à partir de ladite pluralité d'objets de relations entre les éléments constitutifs de la construction identifiés de même catégorie ;
- un calcul à partir des relations déterminées entre les éléments constitutifs de la construction identifiés d'un ensemble de critères définissant ledit assemblage d'éléments,
caractérisé en que, pour assembler lesdits éléments constitutifs de la construction, avant de couler autour un volume de béton :
* ladite représentation graphique se rapporte à :
- un plan de coffrage du volume de béton ;
- un plan de ferraillage ;
- un plan de précontrainte ;
- un plan de modèles de cage de ferraillage ;
- un plan de platines et inserts noyés dans le béton ;
- une combinaison d'au moins deux de ces plans, ou
- une représentation graphique résultant d'une numérisation laser trois dimensions d'un objet préexistant, et/ou
* les catégories d'éléments constitutifs de la construction se rapportent à :
- des éléments de coffrage;
- des réservations;
- des inserts noyés;
- des aciers de ferraillage passif ;
- gaines et câbles de précontrainte ;
- une maquette en trois dimensions d'un volume de la construction, cette maquette étant reconstituée à partir d'une numérisation laser trois dimensions d'un objet préexistant.

2. Procédé selon la revendication précédente, **caractérisé en ce que** ledit ensemble de critères comporte des sous-ensembles de critères définissant chacun un assemblage d'éléments constitutifs de la construction modélisés en trois dimensions pour une catégorie donnée d'éléments constitutifs de cette construction.

3. Procédé selon la revendication précédente, **caractérisé en ce que** chaque sous-ensemble de critères d'assemblage des éléments modélisés permet de générer une interface interactive d'affichage de données comportant une même catégorie d'éléments constitutifs de la construction.

4. Procédé selon l'une des revendications précédentes, caractérisé en que l'objet se rapporte à des éléments graphiques ou textuels compris dans la représentation graphique.

5. Procédé selon l'une des revendications précédentes, **caractérisé en ce qu'**un utilisateur peut modifier au moins un critère d'assemblage desdits éléments modélisés d'un ensemble de critères ou d'un sous-ensemble de critères.

6. Procédé selon l'une des revendications précédentes, **caractérisé en ce qu'il** comprend une étape de détection d'une intersection de volume d'au moins deux éléments d'assemblage modélisés en trois dimensions.

7. Procédé selon la revendication précédente, **caractérisé en ce qu'il** comprend une étape de traitement apte à calculer de nouveaux critères d'assemblage d'un ensemble de critères ou d'un sous-ensemble de critères de sorte à supprimer l'intersection détectée.

8. Procédé selon l'une des revendications 1 à 5, **caractérisé en ce qu'il** comprend une étape de détection d'intersections incompatibles, non identifiées lors d'une phase antérieure de préparation de travaux en liaison avec une pose d'armatures à l'endroit d'un coffrage de maquette numérique préalablement modélisés :
- entre des barres d'acier,
- entre des barres d'acier et le coffrage, pour un respect des enrobages,
- entre des barres d'acier et d'autres pièces à noyer au moins en partie dans le béton.

9. Procédé selon l'une des revendications 6, 7, **caractérisé en ce que** :
- la numérisation laser en trois dimensions d'un objet préexistant comprend l'obtention d'un ensemble de points en trois dimensions illustratifs d'éléments de construction et recalés dans les coordonnées propres à la construction pour laquelle l'interface interactive est à générer, le passage d'une surface triangulée par ces points permettant d'obtenir ladite maquette scannée en trois dimensions,
- puis on fait interagir numériquement cette maquette numérisée avec ledit modèle des éléments constitutifs de cet assemblage, par ailleurs généré pour la construction, afin de détecter lesdites intersections possibles de volume entre des éléments de construction de la maquette et du modèle, respectivement.

10. Programme d'ordinateur comportant des instructions pour l'exécution des étapes du procédé génération d'une interface interactive d'affichage de données relatives à un assemblage d'éléments constitutifs d'une construction architecturale modélisés en trois dimensions selon l'une des revendications 1 à 9 lorsque ledit programme est exécuté par les moyens d'un dispositif informatique.

11. Utilisation, pour assembler des éléments modélisés en trois dimensions et constitutifs d'une construction en béton armé, avant de couler autour un volume de béton, d'un procédé de génération d'une interface interactive globale d'affichage de données relatives à un assemblage d'éléments, comportant les étapes suivantes :
- une réception d'un fichier numérique comportant au moins une représentation graphique ;
- une détection d'une pluralité d'objets compris dans ladite représentation graphique ;
- une identification à partir de ladite pluralité d'objets d'éléments constitutifs de la construction;
- une détermination à partir de ladite pluralité d'objets de relations entre les éléments constitutifs de la construction identifiés de même catégorie ;
- un calcul à partir des relations déterminées entre les éléments constitutifs de la construction identifiés d'un ensemble de critères définissant ledit assemblage d'éléments, ladite représentation graphique se rapportant à :
- un plan de coffrage du volume de béton ;
- un plan de ferraillage ;
- un plan de précontrainte ;
- un plan de modèles de cage de ferraillage ;
- un plan de platines et inserts noyés dans le béton ;
- une combinaison d'au moins deux de ces plans, ou
- une représentation graphique résultant d'une numérisation laser trois dimensions d'un objet préexistant, et/ou les catégories d'éléments constitutifs de la construction se rapportant à :
- des éléments de coffrage;
- des réservations;
- des inserts noyés;
- des aciers de ferraillage passif ;
- des gaines et câbles de précontrainte ;
- une maquette en trois dimensions d'un volume de la construction cette maquette étant reconstituée à partir d'une numérisation laser trois dimensions d'un objet préexistant.
